# EUROPEAN PATENT SPECIFICATION

(11) **EP 1 090 414 B1**
(45) Date of publication and mention of the grant of the patent: **08.12.2004**
(21) Application number: 99924504.6
(22) Date of filing: 26.05.1999
(51) Int. Cl.: H01L 21/00

(54) **RESIN MOLDED ARTICLE FOR CHAMBER LINER**
GEGENSTAND AUS GEGOSSENEM HARZ FÜR EINE KAMMERSCHUTZAUSKLEIDUNG
ARTICLE EN RESINE MOULEE POUR GARNITURE DE CHAMBRE

(30) Priority: 29.05.1998 JP 15013798
(43) Date of publication of application: 11.04.2001
(73) Proprietor: E.I. du Pont de Nemours and Company, Wilmington, DE 19898 (US)
(72) Inventor: NAKAGAWA, Shinichi, Utsunomiya-shi, Tochigi 321-0962 (JP); SAKAI, Shuji, Yokohama, Kanagawa (JP)
(74) Representative: Abitz, Walter, Dr.-Ing.
(86) International application number: PCT/US1999/011554
(87) International publication number: WO 1999/063584

(56) References cited:
- WO-A-96/26791
- US-A- 5 304 279
- US-A- 5 641 375

## Description

### FIELD OF THE INVENTON

The present invention relates to a seamless annular resin molded article for use in a liner within a chamber of a dry etching apparatus used in semiconductor manufacture. More specifically, the invention relates to a resin molded article for a liner, which resin molded article is able to reduce, for an extended period of time, damage to circuits formed on wafers owing to contamination within the liner by heavy metals or reaction products, and the fitting method for which is simple.

### BACKGROUND OF THE INVENTION

A dry etching process that uses plasma has been employed recently in semiconductor manufacture. In this plasma dry etching process, a reactive gas is ionized with a plasma, the ionized gas is induced to react chemically with the material to be etched, and the etched material is removed together with the gas. However, the direction of etching has isotropy, which results in wafer contamination by heavy metals due to sputtering and etching of the liner installed within the chamber in the dry etching apparatus. Alumite-treated aluminum liners have been used to prevent this.

Unfortunately, under severe plasma irradiation conditions, the surface layer of alumite detaches in a relatively short time, resulting in wafer contamination by aluminum particles.

Moreover, to prevent the deposition on the wafer of that portion of the reaction products formed by dry etching which is not discharged as gases but remains instead within the liner, a liner having a construction in which the reaction products deposit on the liner inside wall by heating the liner from the outside, maintaining the liner inside wall at a predetermined temperature, and thus controlling agglomeration of the reaction product is used. Yet, it could not be sufficient to adequately prevent contamination of the wafer by the reaction products.

U.S. Patent 5,304,279 describes a dry-processing apparatus for plasma etching or deposition including a chamber for plasma processing having an external wall which is lined with quartz or another material inert to a plasma and noncontaminating to the work piece.

U.S. Patent 5,641,375 relates to an apparatus for protecting the interior walls of a plasma processing chamber, comprising a removable, flexible shield comprising electrically conductive material, said shield having a first surface resiliently engaging the contours of the interior walls.

To prevent wafer contamination by aluminum particles and reaction products, there has been developed an alumite-treated aluminum liner coated on the inside wall with a dispersion of a polyimide precursor having excellent plasma resistance. However, the applied coat lacks sufficient durability and plasma resistance, and cannot be thickly applied.

Liners are used with a polyimide film obtained from a polyimide precursor, but their durability and plasma resistance are not sufficient, in addition to which a film thickness greater than 0.25 mm cannot be achieved. Moreover, reaction products deposit locally at seams and deposit excessively even when the temperature of the liner inside wall is controlled, which causes the detachment of deposits, resulting in contamination within the liner. Moreover, the film has a tendency to peel off starting at seams. In addition, since an adhesive is used to fit the film to the inside wall of the liner, replacement of the film cannot be easily carried out.

Hence, a need exists for a resin molded article for liners which is able to reduce, for an extended period of time, damages to circuits formed on wafers due to contamination within the liner by heavy metals and reaction products, and which is easy to fit in place and easy to remove.

In is therefore an object of this invention to provide a resin molded article for a liner, which article has excellent plasma resistance and durability, and is also easy to fit into place and easy to remove.

### SUMMARY OF THE INVENTION

We have conducted extensive research to resolve problems such as these. As a result, we have found that damage. to the circuits formed on wafers due to contamination within the liner by heavy metals and reaction products can be reduced for an extended period of time by fitting to the inside wall of the liner a seamless annular or ring-shaped resin molded article having plasma resistance, heat resistance, flexibility, and a predetermined thickness.

Accordingly, the present invention relates to a resin molded article for fitting to an inside wall of a liner in a chamber of a dry etching apparatus used in semiconductor manufacture, said article being a seamless annular molded article that has
(a) a heat resistance temperature of at least 100°C,
(b) a tensile elongation at break of at least 0.3%,
(c) a flexural modulus of at least 10,000 kg/cm²,
(d) an outside diameter from 0 to 0.3% larger than the inside diameter of the liner, and
(e) a wall thickness of not more than 2 mm.

The article is preferably made from polyimide.

In a preferred embodiment of the invention to the above-described resin molded article has a tensile elongation at break of at least 5%, a flexural modulus within a range of 10,000 to 100,000 kg/cm², and an outside diameter from 0.01 to 0.3% larger than the inside diameter of the liner.

The invention further relates to a method of fitting the first above-described resin molded article to the inside wall of an aluminum liner, in a chamber of a dry etching apparatus used in semiconductor manufacture, by (a) heating the liner to about 100°C to cause it to expand, and (b) fitting the molded article inside expanded liner.

The invention also relates to a method of fitting the first above-described resin molded article having
a tensile elongation at break of at least 5%,
a flexural modulus in the range of 10,000 to 100,000 kg/cm², and
an outside diameter from 0.01 to 0.3% larger than the inside diameter of the liner,
to the inside wall of the liner, in a chamber of a dry etching apparatus used in semiconductor manufacture, by either
(a) applying a load to at least one place on the outer periphery of the resin molded article at ambient temperature and pressure to cause it to deflect, and releasing the deflection within the liner
   or by
(b) inserting the resin molded article inside the liner by press-fitting at ambient temperature and pressure.

### BRIEF DESCRIPTION OF THE DRAWINGS

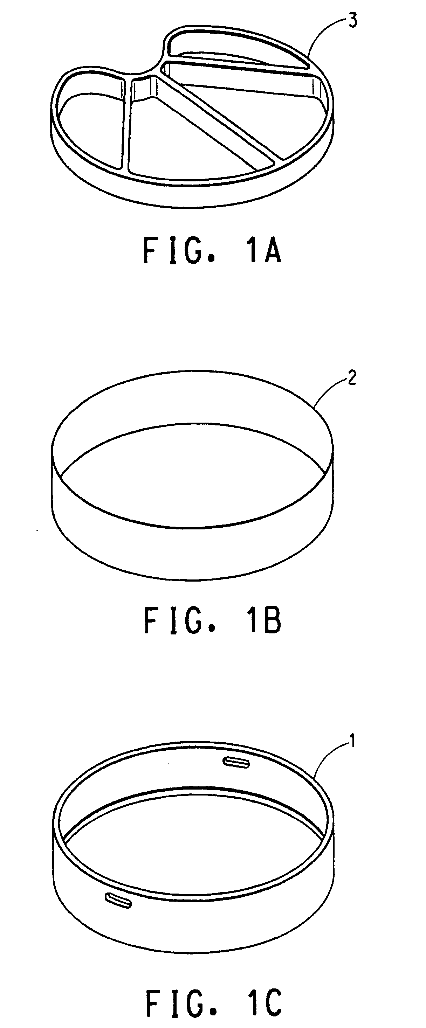

The attached figures show a liner used in the invention, a resin molded body according to one embodiment of the invention; and a fitting tool which can be used to fit the resin molded article of the invention to the inside wall of the liner. FIG. 1(a) shows the fitting tool 3, FIG. 1(b) shows the resin molded article 2, and FIG. 1(c) shows the liner.

### DETAILED DESCRIPTION OF THE INVENTION

The invention is described with reference to attached FIG. 1, wherein FIG. 1(a) is a fitting tool 3 which can be used to fit the resin moulded liner of the invention, FIG. 1(b) is a seamless annular resin molded article 2 according to the present invention, and FIG. 1(c) is a liner 1.

The inventive resin molded article 2 (hereinafter, the reference numerals 1 and 2 are omitted where unnecessary) for a liner is a resin molded article having a heat resistance temperature of at least 100°C, a tensile elongation at break of at least 0.3%, and a flexural modulus of at least 10,000 kg/cm².

The heat resistance temperature is preferably at least 120°C, and more preferably at least 150°C. If the heat resistance temperature is below 100°C, because the dry etching process temperature locally exceeds 100°C, degassing of the resin molded article due to pyrolysis results in contamination of the liner interior.

The resin molded article is a seamless annular molded article having an outside diameter from 0 to 0.3% larger than the inside diameter of the liner, and having a wall thickness of not more than 2 mm. A resin molded article having an outside diameter more than 0.3% larger than the inside diameter of the liner causes localized stress when fitted in place, which is not desirable.

The wall thickness of the resin molded article is preferably from 0.3 to 1.5 mm, and more preferably from 0.5 to 1.0 mm. At a thickness greater than 2 mm, when the liner is heated from the outside, the resin molded article acts as a heat insulator, making it impossible to keep the inside wall of the liner at the predetermined temperature. As a result, the reaction products cannot be induced to deposit on the inside wall of the liner.

Moreover, it is critical that the resin molded article be a seamless annular molded article. If there is a seam, the reaction products deposit locally at the seam and deposit excessively even when the temperature on the inside wall of the liner is controlled, which causes the detachment of deposits, resulting in contamination within the liner. When the resin molded article is not seamless, detachment of the resin molded article from the seam readily arises.

The resin molded article of the present invention for use in a liner can be fitted into place by heating the aluminum liner to about 100°C, causing it to expand. Alternatively, when the molded resin article has a tensile elongation at break of at least 5%, a flexural modulus within a range of 10,000 to 100,000 kg/cm², and an outside diameter from 0.01 to 0.3% larger than the inside diameter of the liner, it can be fitted to the inside wall of the liner by applying a load to at least one place from the outer periphery of the resin molded article at ambient temperature and pressure so as to cause the resin molded article to deflect, then releasing the deflection within the liner. In this case, the resin-molded article may also be inserted by press-fitting at ambient temperature and pressure.

In those cases where the resin molded article is deflected and fit into place as described above at ambient temperature and pressure, fitting of the resin molded article 2 can easily be achieved without damage by using the fitting tool 3 shown in FIG. 1(a).

When the resin molded article of the invention is fitted into place at ambient temperature and pressure by making use of its flexibility, the tensile elongation at break is preferably at least 7%, more preferably at least 10%, and the flexural modulus is preferably within a range of 20,000 to 60,000 kg/cm², more preferably within a range of 20,000 to 40,000 kg/cm². A resin molded article having an outside diameter less than 0.01% larger than the inside diameter of the liner, when exposed to high heat in a vacuum during dry etching, undergoes dehydration shrinkage and loosens. As a result, fitting cannot be carried out without using an adhesive; that is, by relying only on the flexibility of the molded article. The preferred outside diameter must be decided in accordance with the flexibility of the resin used, within the range of the present invention.

The inventive resin molded article having a heat resistance temperature of at least 100°C, a tensile elongation at break of at least 0.3%, and a flexural modulus of at least 10,000 kg/cm² may, for example, be made of a resin powder which includes any one, or mixtures of two or more, of the following: polyphenylene sulfide, liquid crystal polymer, polybenzimidazole, polyimide, polyetherimide, polyamideimide, polyetheretherketone, polycarbonate, polyarylate, tetrafluoroethylene/perfluoroalkylvinyl ether copolymer (PFA), polytetrafluoroethylene (PTFE), polychlorotrifluoroethylene (PCTFE), tetrafluoroethylene/hexafluoropropylene copolymer (FEP), polyvinylidene fluoride (PVDF), ethylene/tetrafluoroethylene copolymer (ETFE), aromatic polyamide, and polyethersulfone.

To carry out fitting without using an adhesive (that is, by relying solely on the flexibility of the resin molded article), the resin molded article must have a tensile elongation at break of at least 5%, and a flexural modulus within a range of 10,000 to 100,000 kg/cm². Illustrative examples include molded articles comprised of any one, or mixtures of two or more, of the following resin powders: polyphenylene sulfide, liquid crystal polymer, polyimide, polyetherimide, polyamideimide, polyetheretherketone, polycarbonate, polyarylate, tetrafluoroethylene/perfluoroalkylvinyl ether copolymer (PFA), polytetrafluoroethylene (PTFE), polychlorotrifluoroethylene (PCTFE), tetrafluoroethylene/hexafluoropropylene copolymer (FEP), polyvinylidene fluoride (PVDF), ethylene/tetrafluoroethylene copolymer (ETFE), aromatic polyamide, and polyethersulfone.

These resin molded articles can be produced by a known molding method suitable for the particular resin powder used. Exemplary molding methods include injection molding and compression molding. Of the above, because polyimide resin powder has a high purity as well as excellent vacuum resistance, high-frequency insulating properties, and antistatic properties, the use of a resin molded article produced by compression molding a polyimide resin powder is preferred.

The resin molded article used in this invention may contain well-known additives which will not become a cause of contamination within the liner. For example, the resin molded article may be obtained by mixing a fluorocarbon resin, molybdenum disulfide or the like with a resin powder, then molding.

### Example 1

A polyimide resin powder manufactured by Du Pont under the registered trademark "Vespel" SP-1 was loaded into a seamless annular mold and compressed at a compression pressure (area) of at least 40,000 psi and a temperature of at least 350°C, giving a polyimide molded article having a heat resistance temperature of 300°C, a tensile elongation at break of 7%, and a flexural modulus of 30,000 kg/cm². This molded article was machined to give a resin molded article 2 having a finished wall thickness of about 1 mm and an outside diameter about 0.2% larger than the inside diameter of the liner.

Using a fitting tool 3, the resulting resin molded article 2 was fitted to the inside wall of an alumite-treated aluminum liner 1 at ambient temperature and pressure.

Dry etching was carried out using primarily a fluorine plasma within a liner fitted with the resin molded article 2, as a result of which damage to circuits formed on wafers that is caused by heavy metal and reaction product contamination within the liner was reduced for a period of more than 150 hours.

### Comparative Example 1

A polyimide precursor dispersion was applied with a spray gun onto the inside wall of an alumite-treated aluminum liner like that used in Example 1, thereby forming a 10 to 50 µm coat, which was then fired at a temperature of over 350°C. Dry etching was carried out using primarily a fluorine plasma within the resulting liner and under the same conditions as in Example 1, as a result of which damage to circuits formed on wafers that was caused by heavy metal and reaction product contamination within the liner was reduced for a period of about 15 hours.

### Comparative Example 2

A polyimide film having a thickness of about 0.25 mm was attached by means of an acrylic adhesive to the inside wall of an alumite-treated aluminum liner like that used in Example 1. Dry etching was carried out using primarily a fluorine plasma within the resulting liner and under the same conditions as in Example 1, as a result of which damage to circuits formed on wafers that was caused by heavy metal and reaction product contamination within the liner was reduced for a period of about 30 hours.

As is apparent from the above results, the seamless annular resin molded articles having distinctive characteristics according to the present invention are able to reduce, for an extended period of time, wafer damage to contamination by heavy metals and reaction products within the liner. Specifically, the resin molded articles of the present invention have been found to achieve a durability at least ten times longer than that of liners provided with a prior-art coating, and about five times longer than that of liners fitted with a film.

## Claims

1. A resin molded article for fitting to an inside wall of a liner in a chamber of a dry etching apparatus used in semiconductor manufacture, said article being a seamless annular molded article that has
(a) a heat resistance temperature of at least 100°C,
(b) a tensile elongation at break of at least 0.3%,
(c) a flexural modulus of at least 10,000 kg/cm²,
(d) an outside diameter from 0 to 0.3% larger than the inside diameter of the liner, and
(e) a wall thickness of not more than 2 mm.

2. A resin molded article according to claim 1 which has a heat resistance temperature of at least 120°C.

3. A resin molded article according to claim 1 which has a tensile elongation at break of at least 5%, a flexural modulus within the range of 10,000 to 100,000 kg/cm², and an outside diameter of from 0.01 to 0.3% larger than the inside diameter of the liner.

4. A resin molded article according to claim 1 which has a flexural modulus of 20,000 to 60,000 kg/cm² and a tensile elongation at break of at least 7%.

5. A resin molded article according to any one of claims 1 to 4 wherein the resin is polyimide.

6. A method of fitting a resin molded article according to claim 1 to the inside wall of an aluminum liner, in a chamber of a dry etching apparatus used in semiconductor manufacture, by (a) heating the liner to about 100°C to cause it to expand, and (b) fitting the molded article inside expanded liner.

7. A method of fitting a resin molded article according to claim 1 having
a tensile elongation at break of at least 5%,
a flexural modulus in the range of 10,000 to 100,000 kg/cm², and
an outside diameter from 0.01 to 0.3% larger than the inside diameter of the liner,
to the inside wall of the liner, in a chamber of a dry etching apparatus used in semiconductor manufacture, by either
(a) applying a load to at least one place on the outer periphery of the resin molded article at ambient temperature and pressure to cause it to deflect, and
(b) releasing the deflection within the liner
or by
inserting the resin molded article inside the liner by press-fitting at ambient temperature and pressure.

8. A method according to claim 7 wherein the tensile elongation at break is at least 7% and the flexural modulus is in the range of 20,000 to 60,000 kg/cm².

## Patentansprüche

1. Formteil aus Kunstharz zum Einsetzen an eine Innenwand einer Auskleidung in einer Kammer eines Geräts zum trockenen Ätzen, das bei der Halbleiterfertigung benutzt wird, wobei besagtes Teil ein nahtloses, ringförmiges Formteil ist, dem eigen sind;
(a) eine Hitzebeständigkeitstemperatur von mindestens 100°C,
(b) eine Bruchdehnung von mindestens 0,3% beim Bruch,
(c) einen Biegeelastizitätsmodul von mindestens 10 000 kg/cm²,
(d) ein Außendurchmesser, der 0 bis 0,3% größer als der Innendurchmesser der Auskleidung ist, und
(e) eine Wanddicke von nicht mehr als 2 mm.

2. Formteil aus Kunstharz gemäß Anspruch 1, das eine Hitzebeständigkeitstemperatur von mindestens 120°C besitzt.

3. Formteil aus Kunstharz gemäß Anspruch 1, dem eigen sind; eine Bruchdehnung von mindestens 5% beim Bruch, ein Biegeelastizitätsmodul, der innerhalb des Bereichs von 10 000 bis 100 000 kg/cm² liegt und ein Außendurchmesser, der 0,01 bis 0,3% größer ist als der Innendurchmesser der Auskleidung.

4. Formteil aus Kunstharz gemäß Anspruch 1, dem eigen sind; ein Biegeelastizitätsmodul von 20.000 bis 60 000 kg/cm² und eine Bruchdehnung von mindestens 7% beim Bruch.

5. Formteil aus Kunstharz gemäß irgendeinem der Ansprüche 1 bis 4, wobei das Kunstharz ein Polyimid ist.

6. Verfahren zum Einsetzen eines Formteils aus Kunstharz gemäß Anspruch 1 an die Innenwand einer Aluminiumauskleidung in einer Kammer eines Gerätes, das zur trockenen Ätzung bei der Halbleiterfertigung benutzt wird, durch (a) Aufheizen der Auskleidung auf etwa 100°C zum Bewirken einer Ausdehnung derselben und durch (b) Einsetzen des Formteils in die Innenseite der ausgedehnten Auskleidung.

7. Verfahren zum Einsetzen eines Formteils aus Kunstharz gemäß Anspruch 1 mit einer Bruchdehnung von mindestens 5% beim Bruch, einem Biegeelastizitätsmodul im Bereich von 10 000 bis 100 000 kg/cm², und einem Außendurchmesser, der 0,01 bis 0,3% größer ist als der Innendurchmesser der Auskleidung an die Innenwand der Auskleidung in einer Kammer eines Geräts, das in der Halbleiterfertigung zum trockenen Ätzen benutzt wird, durch entweder (a) Aufbringung einer Belastung an mindestens einer Stelle auf dem äußeren Umfang des Formteils aus Kunstharz bei Umgebungstemperatur und Umgebungsdruck, um es zum Durchbiegen zu bringen, und (b) durch Lösen der Durchbiegung innerhalb der Auskleidung, oder durch Einsetzen des Formteils aus Kunstharz in die Auskleidung hinein durch eine Presspassung bei Umgebungstemperatur und Umgebungsdruck.

8. Verfahren gemäß Anspruch 7, wobei die Bruchdehnung mindestens 7% beim Bruch beträgt und der Biegeelastizitätsmodul im Bereich von 20 000 bis 60 000 kg/cm² liegt.

## Revendications

1. Article de résine moulé pour s'ajuster à la paroi intérieure d'une doublure, dans une chambre d'un appareil de gravure à sec utilisé dans la fabrication de semi-conducteurs, ledit article étant un article moulé annulaire sans soudure qui possède:
(a) une température de résistance thermique d'au moins 100°C,
(b) un allongement à la rupture de traction d'au moins 0,3%,
(c) un module de flexion d'au moins 10.000 kg/cm²,
(d) un diamètre extérieur de 0 à 0,3% plus grand que le diamètre intérieur de la doublure, et
(e) une épaisseur de paroi de pas plus de 2 mm.

2. Article de résine moulé suivant la revendication 1, qui possède une température de résistance thermique d'au moins 120°C.

3. Article de résine moulé suivant la revendication 1, qui possède un allongement à la rupture de traction d'au moins 5%, un module de flexion dans l'intervalle de 10.000 à 100.000 kg/cm² et un diamètre extérieur de 0,01 à 0,3% plus grand que le diamètre intérieur de la doublure.

4. Article de résine moulé suivant la revendication 1, qui possède un module de flexion de 20.000 à 60.000 kg/cm² et un allongement à la rupture de traction d'au moins 7%.

5. Article de résine moulé suivant l'une quelconque des revendications 1 à 4, dans lequel la résine est un polyimide.

6. Procédé pour l'ajustement d'un article de résine moulé suivant la revendication 1 à la paroi intérieure d'une doublure d'aluminium, dans une chambre d'un appareil de gravure à sec utilisé dans la fabrication de semi-conducteurs, (a) en chauffant la doublure à environ 100°C pour la faire se dilater et (b) en ajustant l'article moulé à l'intérieur de la doublure dilatée.

7. Procédé pour l'ajustement d'un article de résine moulé suivant la revendication 1 possédant:
un allongement à la rupture de traction d'au moins 5%, un module de flexion dans l'intervalle de 10.000 à 100.000 kg/cm², et un diamètre extérieur de 0,01 à 0,3% plus grand que le diamètre intérieur de la doublure, à la paroi intérieure de la doublure, dans une chambre d'un appareil de gravure à sec utilisé dans la fabrication de semi-conducteurs, soit (a) en appliquant une charge à au moins un endroit sur la périphérie extérieure de l'article de résine moulé à une température et une pression ambiantes pour le faire fléchir et (b) en relâchant le fléchissement dans la doublure, soit en insérant l'article de résine moulé à l'intérieur de la doublure par un ajustement à la presse à une température et une pression ambiantes.

8. Procédé suivant la revendication 7, dans lequel l'allongement à la rupture de traction est d'au moins 7% et le module de flexion est dans l'intervalle de 20.000 à 60.000 kg/cm².
